# EUROPÄISCHE PATENTSCHRIFT

(11) **EP 2 296 946 B1**
(45) Veröffentlichungstag und Bekanntmachung des Hinweises auf die Patenterteilung: **29.05.2013**
(21) Anmeldenummer: 09765836.3
(22) Anmeldetag: 16.06.2009
(51) Int. Cl.: G01D 11/24, H05K 1/14, B60S 1/08, G01D 11/30

(54) **SENSORANORDNUNG**
SENSOR ARRANGEMENT
ENSEMBLE DETECTEUR

(30) Priorität: 18.06.2008 DE 102008028977
(43) Veröffentlichungstag der Anmeldung: 23.03.2011
(73) Patentinhaber: Leopold Kostal GmbH & Co. KG, 58513 Lüdenscheid (DE)
(72) Erfinder: RÖHR, Michael, 44265 Dortmund (DE); HAGEN, Frank, 58511 Lüdenscheid (DE); WEBER, Thomas, 58513 Lüdenscheid (DE)
(74) Vertreter: Kerkmann, Detlef
(86) Internationale Anmeldenummer: PCT/EP2009/057459
(87) Internationale Veröffentlichungsnummer: WO 2009/153256

(56) Entgegenhaltungen:
- WO-A-2008/014911
- DE-A1-102006 022 404
- DE-A1-102006 032 372
- DE-A1-102006 060 546
- DE-A1-102006 060 547
- DE-A1-102006 060 548
- DE-U1-202006 010 426

## Beschreibung

Die Erfindung betrifft eine Sensoranordnung mit wenigstens einem optischen Sensor und einem nichtoptischen Sensor, die mittels eines Sensorhalters an einer Fahrzeugscheibe befestigbar sind, wobei der nichtoptische Sensor von einem an dem Sensorhalter angeformten Ausleger gehalten ist, wobei der Sensorhalter als ein Sensorgehäuse ausgebildet ist, das aus einem Sensorgehäusekörper und einem Sensorgehäusedeckel besteht, wobei das Sensorgehäuse einen Hauptschaltungsträger aufnimmt, mit dem Teile des optischen Sensors verbunden sind, und wobei der nichtoptische Sensor über einen flexiblen Schaltungsträger mit dem Hauptschaltungsträger verbunden ist.

Eine derartige Sensoranordnung ist aus der deutschen Patentanmeldung DE 10 2006 022 404 A1 bekannt.

Aus der deutschen Gebrauchsmusterschrift DE 20 2006 010 426 U1 ist eine Vorrichtung zum Befestigen von Sensoren bekannt, die im wesentlichen durch einen als Stanzbiegeteil gefertigten Sensorhalter ausgebildet ist. Der den Sensorhalter ausbildende Blechrahmen kann mit einem nicht näher beschriebenen, mit der Fahrzeugscheibe verbundenen Trägerteil verrastet werden. Der Sensorhalter befestigt zentral einen Regensensor und weist zudem eine angeformte seitlich abstehende federnde Haltezunge auf, die einen im Vergleich zum Regensensor kleinbauenden Beschlagsensor haltert.

Der DE 20 2006 010 426 U1 ist nicht zu entnehmen, wie ein die Sensorvorrichtung umschließendes Deckelteil auf vorteilhafte Weise ausgeführt sein könnten. Auch finden sich keine Angaben wie die elektrische Anbindung des Beschlagsensors auf vorteilhafte Weise zu realisieren wäre. Es stellte sich die Aufgabe, eine Sensoranordnung mit wenigstens einem optischen und einem nichtoptischen Sensor zu schaffen, die sich durch einen einfachen und kostengünstigen Gesamtaufbau und durch eine vorteilhaft ausgestaltete Anordnung der Sensoren auszeichnet.

Diese Aufgabe wird erfindungsgemäß dadurch gelöst, dass eine am Ausleger gehaltene Feder den nichtoptischen Sensor in Richtung der Fahrzeugscheibe presst.

Die erfindungsgemäße Sensoranordnung zeichnet sich unter anderem dadurch aus, dass die Sensoren auf mehrere Schaltungsträgern verteilt montiert sind, wobei wenigstens der nichtoptische Sensor auf einem flexiblen Schaltungsträger angeordnet ist. Durch die Verbindung des flexiblen Schaltungsträger mit dem Hauptschaltungsträger bilden die beiden Sensoren eine elektrische Einheit, die über einen gemeinsamen elektrischen Anschluss der Sensoranordnung kontaktiert werden kann. Zur vorteilhaften Anordnung des nichtoptischen Sensors ist vorgesehen, dass dieser durch stegförmige Anformungen am Ausleger des Sensorgehäuses gehalten wird und durch eine Feder an die Fahrzeugscheibe anpressbar ist.

Die beiden Schaltungsträger können als eine, insbesondere vormontierbare, mechanische Einheit mit dem Sensorgehäuse verbunden werden. Besonders vorteilhaft ist, dass hinsichtlich der Anordnung der Sensoren relativ zueinander, keine engen Toleranzen einzuhalten sind, da mögliche Toleranzen durch die flexible Verbindung zwischen den Sensoren ausgeglichen werden können.

Vorteilhaft ist auch, dass der flexible Schaltungsträger auf einfache Weise eine federnde Lagerung des nichtoptischer Sensors am Ausleger des Sensorgehäuses ermöglicht.

Vorteilhaft ist auch, dass der Ausleger nicht als ein separat anzufügendes Teil sondern als Bestandteil des Sensorgehäuses ausgeführt ist, der durch an den Sensorgehäusekörper und den Sensorgehäusedeckel einstückig angeformte Abschnitte ausgebildet ist.

Besonders vorteilhaft ist, dass die gesamte Sensoranordnung durch das Zusammenfügen von nur wenigen Einzelteilen in aufbauender Montage gefertigt werden kann.

Weitere vorteilhafte Ausgestaltungen und Weiterbildungen der Erfindungen gehen aus den abhängigen Ansprüchen hervor.

So ist es vorteilhaft wenn der Hauptschaltungsträger und der flexible Schaltungsträger vor der Montage in das Sensorgehäuse miteinander vormontiert sind. Die beiden Schaltungsträger können so auf eine besonders einfache und kostengünstige Weise, etwa über eine Lötverbindung elektrisch und mechanisch miteinander verbunden sein und als eine Baueinheit auf einfache Weise an das Sensorgehäuse angefügt werden.

Alternativ kann auch vorgesehen sein, die elektrische Verbindung der beiden Schaltungsträger über einen Steckverbinder herzustellen. Die beiden Schaltungsträger können dadurch bedarfsweise entweder vor oder nach der Montage an das Sensorgehäuse miteinander verbunden werden. Darüber hinaus ist ein nachträglicher Austausch eines Schaltungsträgers und des zugehörigen Sensors jederzeit leicht möglich.

Der nichtoptische Sensor kann vorteilhaft einen Beschlagsensor ausbilden. In einer bevorzugten Ausführungsform besteht dieser aus einer Kombination eines Temperatur- und eines Luftfeuchtigkeitssensors.

Ein vorteilhaftes Ausführungsbeispiel einer Sensoranordnung wird nachfolgend anhand der Zeichnung näher beschrieben. Es zeigen
- Figur 1: eine Ansicht eines Sensorgehäusedeckels mit montierten elektronischen Komponenten,
- Figur 2: eine Ansicht eines Sensorgehäusekörpers,
- Figur 3: eine erste Ansicht einer Sensoranordnung,
- Figur 4: eine zweite Ansicht der Sensoranordnung,
- Figur 5: eine Ansicht der Halterung eines nichtoptischen Sensors am Sensorgehäusedeckel,
- Figur 6: eine Ansicht nach Figur 5 mit einem angefügtem Sensorgehäusekörper,
- Figur 7: eine Schnittansicht durch die Figur 6.

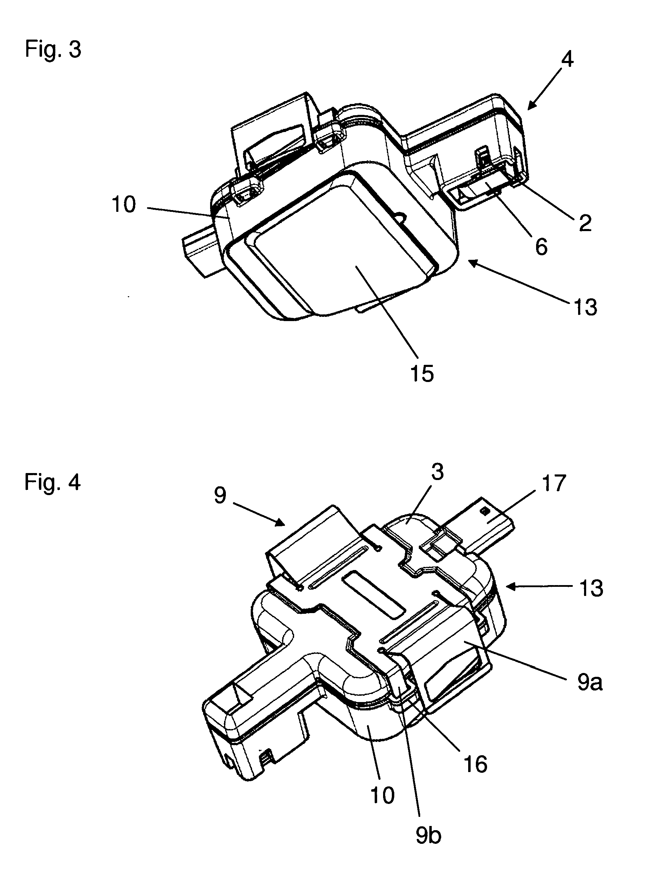

Die Figuren 3 und 4 zeigen eine Sensoranordnung, die an ein nicht dargestelltes Trägerteil anfügbar ist, welches mit einer ebenfalls nicht dargestellten Fahrzeugscheibe verbunden ist. Alternativ kann die Sensoranordnung auch auf die Fahrzeugscheibe aufgeklebt sein.

Die Sensoranordnung weist einen optischen Sensor und einen nichtoptischen Sensor auf, wobei ersterer hier beispielhaft als ein kombinierter Regen- und Lichtsensor und letzterer als ein Beschlagsensor ausgebildet ist. Der Beschlagsensor ist nachfolgend als Kombination eines Temperatursensors und eines Luftfeuchtigkeitssensors beschrieben.

Die Figur 3 zeigt die der Fahrzeugscheibe zugewandte Seite der Sensoranordnung. Erkennbar ist an der Unterseite des Sensorgehäuses 13 eine beispielsweise aus Silikon bestehende Ankoppelfläche 15 zur Ankopplung des optischen Sensors an die Fahrzeugscheibe. Innerhalb des an das Sensorgehäuse 13 angeformten Auslegers 4 ist ein Abschnitt eines flexiblen Schaltungsträgers 6 dargestellt, der durch eine innerhalb des Auslegers 4 angeordnete Druckfeder an die Fahrzeugscheibe anpressbar ist, und der auf seiner zum Inneren des Sensorgehäuses 13 gewandten Seite einen in dieser Figur nicht erkennbaren Beschlagsensor trägt.

Der Blick auf die Oberseite des Sensorgehäuses 13, dargestellt in der Figur 4, zeigt einen Spannbügel 9, der erste Federhaken 9a aufweist, mit denen der Spannbügel 9 das Sensorgehäuse 13 mit einem nicht dargestellten, mit der Fahrzeugscheibe verbundenen Trägerteil verbindet und der zweite Federhaken 9b aufweist, mittels derer der Spannbügel 9 das aus Sensorgehäusekörper 10 und Sensorgehäusedeckel 3 bestehende Sensorgehäuse 13 zusammenhält. Dazu greifen die zweiten Federhaken 9b rastend in Rastösen 16 des Sensorgehäusekörpers 10 ein, wodurch der federnde Spannbügel 9 den Sensorgehäusedeckel 3 gegen den Sensorgehäusekörper 10 presst.

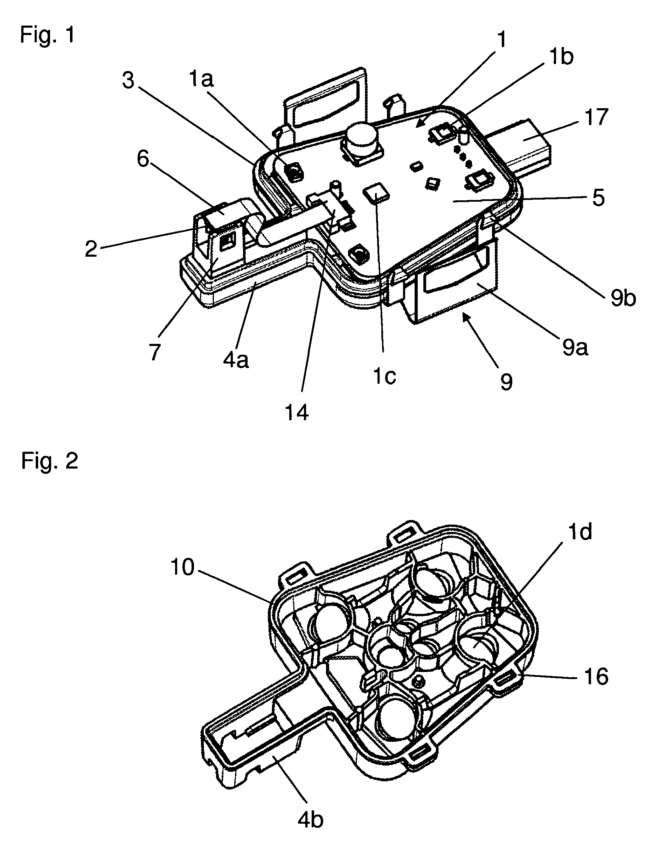

Die Figuren 1 und 2 zeigen das geöffnete Sensorgehäuse 13 mit jeweils einer Innenansicht des Sensorgehäusedeckels 3 und des Sensorgehäusekörpers 10.

Die Figur 1 zeigt eine Leiterplatte 5, die als Hauptschaltungsträger in einen rahmenartigen Abschnitt des Sensorgehäusedeckels 3 eingelegt ist. Die Leiterplatte 5 trägt insbesondere die elektronischen Komponenten (1 a, 1 b, 1 c) eines optischen Sensors 1, zu denen mehrere Lichtsender 1 a und mehrere Lichtempfänger (1 b, 1 c) gehören. Darüber hinaus sind weitere, hier nicht näher bezeichnete elektronische Komponenten auf der Leiterplatte 5 vorhanden, die insbesondere eine vollständige Auswerteschaltung für Sensorsignale ausbilden können. Die Leiterplatte 5 stellt des weiteren die Verbindung zu einem elektrischen Anschluss 17 her, ausgeführt vorzugsweise als ein Steckverbinderanschluss an der Außenseite des Sensorgehäusedeckels 3, über den die Ausgangssignale der Sensoranordnung abgegriffen werden können.

Auf der Oberseite der Leiterplatte 5 befindet sich ein Steckverbinder 14, der eine elektrische Verbindung von der Leiterplatte 5 zu einem flexiblen Schaltungsträger 6 herstellt, der beispielsweise als eine flexible Leiterplatte, eine Leiterfolie oder auch durch eine sogenannte Starrflex-Leiterplatte ausgebildet sein kann, die neben den flexiblen auch abschnittsweise starre Bereiche aufweist.

Bei der Montage können die Leiterplatte 5 und der flexible Schaltungsträger 6 miteinander vormontiert sein und gemeinsam an den Sensorgehäusedeckel 3 angefügt werden. Hierdurch entsteht eine gut handhabbare Baugruppe, die anschließend auf einfache Weise mit dem Sensorgehäusekörper 10 verbindbar ist.

Der flexible Schaltungsträger 6 ist zu einem am Sensorgehäusedeckel 3 angeformten Abschnitt 4a geführt, welcher zwei parallel zueinander angeordnete, vom Abschnitt 4a senkrecht abstehende Stege 7 aufweist, die den nichtoptischen Sensor 2 federnd haltern.

Der Sensorgehäusekörper 10, dargestellt in der Figur 2, weist eine eingefügte oder angeformte Lichtleiteranordnung 1 d auf, die zusammen mit den elektronischen Komponenten (1 a, 1 b, 1 c) und der in der Figur 3 gezeigten Ankoppelfläche 15 mehrere optische Sensoren bildet. Die Lichtleiteranordnung 1 d errichtet dazu Lichtstrecken zwischen Lichtsendern 1a und Lichtempfängern 1 b, über die Benetzungen der Fahrzeugscheibe optisch detektiert werden können. Ein weiterer Lichtempfänger 1 c auf der Leiterplatte 5 erhält über die Lichtleiteranordnung 1 d Licht aus der Umgebung des Fahrzeugs zugeführt, und detektiert somit die Helligkeit der Fahrzeugumgebung.

Deutlich erkennbar sind die am Rand des Sensorgehäusekörpers 10 angeformte Rastösen 16, in die beim Zusammenfügen des Sensorgehäusekörpers 10 mit dem Sensorgehäusedeckel 3 die zweiten Federhaken 9b des Spannbügels 9 rastend eingreifen.

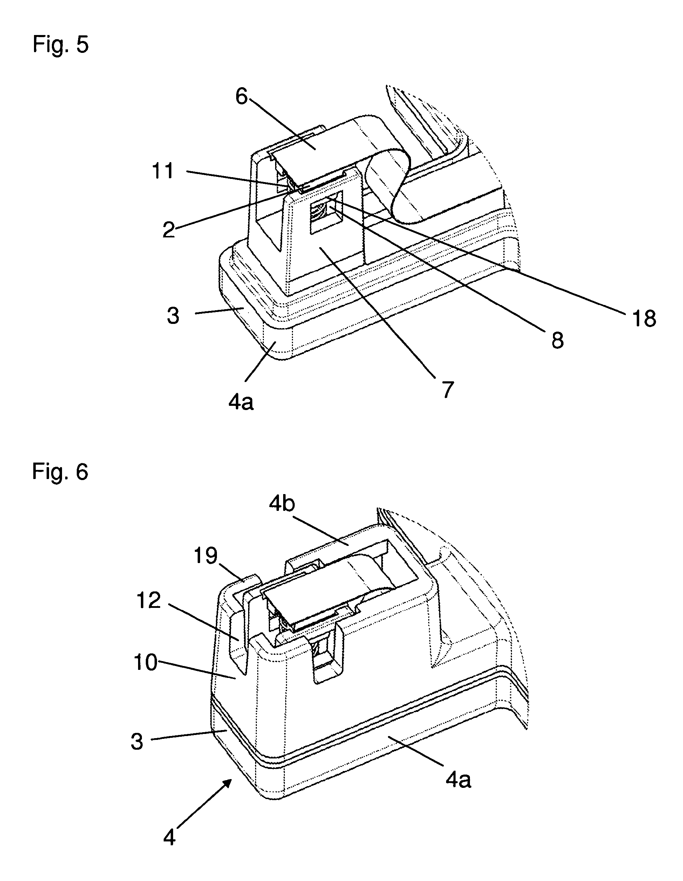

Der Sensorgehäusekörper 10 weist einen angeformten Abschnitt 4b auf, der den Abschnitt 4a des Sensorgehäusedeckels 3 übergreift und mit diesem zusammen den Ausleger 4 des Sensorgehäuses 13 ausbildet. Dies ist besonders deutlich in der Figur 6 erkennbar.

Die Figur 5 zeigt den Abschnitt 4a des Sensorgehäusedeckels 3 in einer Ausschnittsvergrößerung der Figur 1. Zwei zueinander parallel angeordneten Stege 7 am Abschnitt 4a weisen jeweils eine Ausnehmung 8 auf, in die jeweils ein klipsartiger Abschnitt 18 des nichtoptischen Sensors 2 eingreift. Die klipsartigen Abschnitte 18 sind in vertikaler Richtung entlang der Ausnehmungen 8 verschiebbar. Durch eine zwischen den Stegen 7 angeordnete Druckfeder 11 wird der Sensor von der Grundfläche des Abschnitts 4a weggedrückt, so dass der nichtoptische Sensor 2 und der mit diesem verbundene flexible Schaltungsträger 6 ein Stück weit über den oberen Randabschnitt der Stege 7 hinausragt.

Dies gilt entsprechend für die Darstellung der Figur 6, in der der Sensorgehäusedeckel 3 mit dem Sensorgehäusekörper 10 zusammengefügt ist, und der Abschnitt 4b des Sensorgehäusekörpers 10 die parallelen Stege 7 übergreift. Der Sensorgehäusekörper 10 stabilisiert die Stege 7 und verhindert, dass die klipsartigen Abschnitte 18 des nichtoptischen Sensors 2 aus den Ausnehmungen 8 der parallelen Stege 7 herausrutschen. Die Stege 7 werden dazu außen vom Sensorgehäusekörper 10 umfasst. Darüber hinaus können auch in der Zeichnung nicht dargestellte Rippen am Sensorgehäusekörper 10 vorgesehen sein, die sich zwischen die Stege 7 einfügen und ein Verbiegen der Stege 7 nach innen und damit ein Einklemmen des nichtoptischen Sensors 2 zwischen den Stegen 7 verhindern. Der nichtoptische Sensor 2 und der flexible Schaltungsträger 6 überragen die obere Berandung 19 des Sensorgehäusekörpers 10. Da nach der Montage des Sensorgehäuses 13 diese Berandung 19 des Sensorgehäusekörpers 10 an der Fahrzeugscheibe anliegt, wird die äußere Seite des flexiblen Schaltungsträgers 6 durch die Druckfeder 11 gegen die Fahrzeugscheibe gepresst, wodurch der auf der Rückseite des flexiblen Schaltungsträgers 6 angeordnete nichtoptische Sensor 2, zu dem, wie erwähnt, auch ein Temperatursensor gehört, thermisch gut an die Fahrzeugscheibe angekoppelt ist.

Da der nichtoptische Sensor 2 zudem einen Luftfeuchtigkeitssensor aufweist, sind in die Seitenwände des Sensorgehäusekörpers 10 um den nichtoptischen Sensor 2 herum Aussparungen 12 eingebracht, die die Belüftung des Luftfeuchtigkeitssensor unterstützen.

Aus den kombinierten Messwerten von Scheibentemperatur und Luftfeuchtigkeit ermittelt eine Auswerteschaltung die momentane Beschlagsneigung, so dass bereits vor dem Auftreten von Beschlag auf der Fahrzugscheibe eine geeignete Reaktion eingeleitet werden kann.

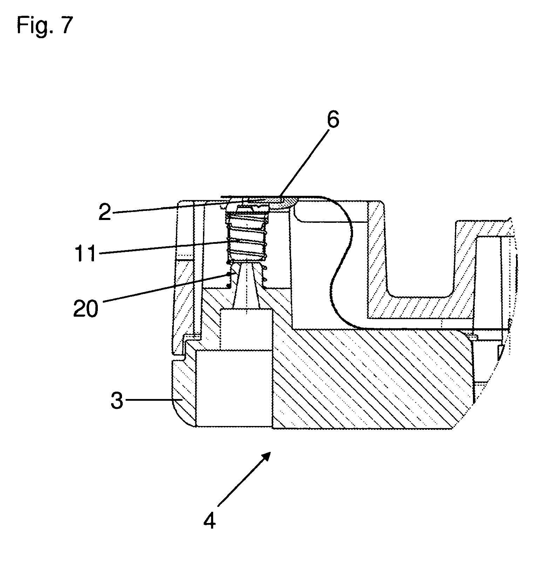

Die Figur 7 zeigt zur Verdeutlichung einen Schnitt durch die in der Figur 6 dargestellte Anordnung. Besonders gut erkennbar ist hier die Druckfeder 11, die auf einem auf dem Sensorgehäusedeckel 3 angeformten Dom 20 gelagert ist. Der sehr schmale Querschnitt des flexiblen Schaltungsträgers 6 ermöglicht es, den nichtoptischen Sensor 2 über den flexiblen Schaltungsträger 6 an der Fahrzeugscheibe anzukoppeln. Durch die flexible Ausführung des Schaltungsträgers 6 wird zudem die federnd gelagerte Anordnung des nichtoptischen Sensors 2 ermöglicht.

### Bezugszeichen

| | |
|---|---|
| 1 | optischer Sensor |
| 1 a | Lichtsender |
| 1b, 1c | Lichtempfänger |
| 1 d | Lichtleiteranordnung |
| 2 | nichtoptischer Sensor |
| 3 | Sensorgehäusedeckel |
| 4 | Ausleger |
| 4a, 4b | Abschnitte (des Auslegers 4) |
| 5 | Hauptschaltungsträger (Leiterplatte) |
| 6 | flexibler Schaltungsträger (Leiterfolie) |
| 7 | Stege |
| 8 | Ausnehmungen (zum Einklipsen des nichtoptischen Sensors) |
| 9 | Spannbügel |
| 9a | erste Federhaken |
| 9b | zweite Federhaken |
| 10 | Sensorgehäusekörper |
| 11 | (Druck)feder |
| 12 | Aussparungen (zur Belüftung) |
| 13 | Sensorgehäuse |
| 14 | Steckverbinder |
| 15 | Ankoppelfläche |
| 16 | Rastösen |
| 17 | elektrischer Anschluss |
| 18 | klipsartige Abschnitte (des nichtoptischen Sensors) |
| 19 | Berandung |
| 20 | Dom |

## Patentansprüche

1. Sensoranordnung mit wenigstens einem optischen Sensor (1) und einem nichtoptischen Sensor (2), die mittels eines Sensorhalters an einer Fahrzeugscheibe befestigbar sind, wobei der nichtoptische Sensor (2) von einem an dem Sensorhalter angeformten Ausleger (4) gehalten ist,
wobei der Sensorhalter als ein Sensorgehäuse (13) ausgebildet ist, das aus einem Sensorgehäusekörper (10) und einem Sensorgehäusedeckel (3) besteht,
wobei das Sensorgehäuse (13) einen Hauptschaltungsträger (5) aufnimmt, mit dem Teile (1a,1b) des optischen Sensors (1) verbunden sind, und
wobei der nichtoptische Sensor (2) über einen flexiblen Schaltungsträger (6) mit dem Hauptschaltungsträger (5) verbunden ist,
**dadurch gekennzeichnet,**
**dass** eine am Ausleger (4) gehaltene Feder (11) den nichtoptischen Sensor (2) in Richtung der Fahrzeugscheibe presst.

2. Sensoranordnung nach Anspruch 1, **dadurch gekennzeichnet, dass** der flexible Schaltungsträger (6) eine Leiterfolie oder eine flexible Leiterplatte ist.

3. Sensoranordnung nach Anspruch 1, **dadurch gekennzeichnet, dass** der nichtoptische Sensor (2) ein Sensor zur Erfassung einer Beschlagsbildung auf der Fahrzeugscheibe ist.

4. Sensoranordnung nach Anspruch 1, **dadurch gekennzeichnet, dass** der nichtoptische Sensor (2) ein bevorstehendes Beschlagen der Fahrzeugscheibe noch vor dem Auftreten einer konkreten Beschlagbildung auf der Fahrzeugscheibe erkennt.

5. Sensoranordnung nach Anspruch 1 oder 4, **dadurch gekennzeichnet, dass** der nichtoptische Sensor (2) einen Temperatursensor und/oder Luftfeuchtigkeitssensor umfasst.

6. Sensoranordnung nach Anspruch 1, **dadurch gekennzeichnet, dass** der optische Sensor (1) einen Regensensor und/oder Lichtsensor ausbildet.

7. Sensoranordnung nach Anspruch 1, **dadurch gekennzeichnet, dass** der mit dem nichtoptischen Sensor (2) versehene Abschnitt des flexiblen Schaltungsträgers (6) an der Fahrzeugscheibe anliegt.

8. Sensoranordnung nach Anspruch 1, **dadurch gekennzeichnet, dass** der nichtoptische Sensor (2) von zwei Stegen (7) am Ausleger (4) gehalten ist.

9. Sensoranordnung nach Anspruch 8, **dadurch gekennzeichnet, dass** die beiden Stege (7) parallel zueinander angeordnet sind.

10. Sensoranordnung nach Anspruch 8 oder 9, **dadurch gekennzeichnet, dass** die Stege (7) von dem Sensorgehäusekörper (10) zumindest teilweise umgeben sind.

11. Sensoranordnung nach Anspruch 10, **dadurch gekennzeichnet, dass** in den die Stege (7) umgebenden Bereich des Sensorgehäusekörper (10) Aussparungen (12) zur Belüftung des nichtoptischen Sensors (2) eingebracht sind.

12. Sensoranordnung nach Anspruch 1, **dadurch gekennzeichnet, dass** der flexible Schaltungsträger (6) über einen Steckverbinder (14) mit dem Hauptschaltungsträger (5) verbunden ist.

13. Sensoranordnung nach Anspruch 1, **dadurch gekennzeichnet, dass** der nichtoptische Sensor (2) federnd am Ausleger (4) gelagert ist.

## Claims

1. Sensor arrangement having at least one optical sensor (1) and a non-optical sensor (2) which are attachable to the windscreen of a vehicle by means of a sensor holder, for which purpose the non-optical sensor (2) is retained by an extension (4) moulded onto the sensor holder,
with the sensor holder designed as a sensor housing (13) comprising a sensor housing body (10) and a sensor housing cover (3),
with the sensor housing (13) accommodating a main circuit carrier (5) to which elements (1a, 1 b) of the optical sensor (1) are connected, and
with the non-optical sensor (2) being connected to the main circuit carrier (5) by way of a flexible circuit carrier (6),
**characterised in that**
a spring (11) supported on the extension (4) presses the non-optical sensor (2) towards the windscreen of the vehicle.

2. Sensor arrangement according to Claim 1, **characterised in that** the flexible circuit carrier (6) is a conducting film or a flexible printed circuit board.

3. Sensor arrangement according to Claim 1, **characterised in that** the non-optical sensor (2) is a sensor for detecting any formation of condensation on the windscreen of the vehicle.

4. Sensor arrangement according to Claim 1, **characterised in that** the non-optical sensor (2) identifies any imminent fogging of the windscreen of the vehicle even before the occurrence of any concrete condensation on the windscreen of the vehicle.

5. Sensor arrangement according to Claim 1 or Claim 4, **characterised in that** the non-optical sensor (2) comprises a temperature sensor and/or a humidity sensor.

6. Sensor arrangement according to Claim 1, **characterised in that** the optical sensor (1) constitutes a rain sensor and/or a light sensor.

7. Sensor arrangement according to Claim 1, **characterised in that** the section of the flexible circuit carrier (6) provided with the non-optical sensor (2) lies closely against the windscreen of the vehicle.

8. Sensor arrangement according to Claim 1, **characterised in that** the non-optical sensor (2) is held on the extension (4) by means of two webs (7).

9. Sensor arrangement according to Claim 8, **characterised in that** the two webs (7) are arranged parallel to each other.

10. Sensor arrangement according to Claim 8 or Claim 9, **characterised in that** the webs (7) are at least partially surrounded by the sensor housing body (10).

11. Sensor arrangement according to Claim 10, **characterised in that** cut-outs (12) are set into the area of the sensor housing body (10) surrounding the webs (7) for the purpose of ventilating the non-optical sensor (2).

12. Sensor arrangement according to Claim 1, **characterised in that** the flexible circuit carrier (6) is connected to the main circuit carrier (5) by way of a plug-type connector (14).

13. Sensor arrangement according to Claim 1, **characterised in that** the non-optical sensor (2) is resiliently supported on the extension (4).

## Revendications

1. Agencement de détection avec au moins un capteur optique (1) et un capteur non optique (2), qui peuvent être fixés sur une glace d'un véhicule automobile au moyen d'un support de-capteurs, sachant que le capteur non optique (2) est maintenu par une pièce en saillie (4), qui est formée sur le support de capteurs,
sachant que le support de-capteurs est réalisé sous la forme d'un boîtier de capteur (13), qui consiste en un corps de boîtier de capteur (10) et en un couvercle de boîtier de capteur (3),
sachant que le boîtier de capteur (13) reçoit un support de circuit de commutation principal (5), auquel sont reliés des éléments (1 a, 1 b) du capteur optique (1), et
sachant que le capteur non optique (2) est relié au support de circuit de commutation principal (5) par l'intermédiaire d'un support de circuit de commutation flexible (6),
**caractérisé en ce que**,
sur la pièce en saillie (4), est fixé un ressort (11), qui presse le capteur non optique (2) en direction de la glace du véhicule automobile.

2. Agencement de détection selon la revendication 1, **caractérisé en ce que** le support de circuit de commutation flexible (6) est une feuille conductrice ou une plaquette de circuits imprimés flexible.

3. Agencement de détection selon la revendication 1, **caractérisé en ce que** le capteur non optique (2) est un capteur, destiné à détecter la formation de buée sur la glace du véhicule.

4. Agencement de détection selon la revendication 1, **caractérisé en ce que** le capteur non optique (2) détecte déjà une buée imminente avant une formation concrète de celle-ci sur la glace du véhicule.

5. Agencement de détection selon revendication 1 ou 4, **caractérisé en ce que** le capteur non optique (2) comprend un capteur de température et / ou un détecteur d'humidité de l'air.

6. Agencement de détection selon la revendication 1, **caractérisé en ce que** le capteur optique (1) forme un capteur de pluie et / ou un capteur de lumière.

7. Agencement de détection selon la revendication 1, **caractérisé en ce que** la section du support de circuit de commutation flexible (6) pourvu du capteur non optique (2) porte contra la glace du véhicule.

8. Agencement de détection selon la revendication 1, **caractérisé en ce que** le capteur non optique (2) est maintenu sur la pièce en saillie (4) par deux pattes (7).

9. Agencement de détection selon la revendication 8, **caractérisé en ce que** les deux pattes (7) sont disposées parallèlement par rapport l'une à l'autre.

10. Agencement de détection selon revendication 8 ou 9, **caractérisé en ce que** les pattes (7) sont entourées, au moins partiellement, par le corps de boîtier de capteur (10).

11. Agencement de détection selon la revendication 10, **caractérisé en ce que** des évidements (12), servant à l'aération du capteur non optique (2), sont pratiqués dans la région du corps de boîtier de capteur (10) qui entoure les pattes (7).

12. Agencement de détection selon la revendication 1, **caractérisé en ce que** le support de circuit de commutation flexible (6) est relié au support de circuit de commutation principal (5) par l'intermédiaire d'un connecteur à fiches (14).

13. Agencement de détection selon la revendication 1, **caractérisé en ce que** le capteur non optique (2) est monté élastiquement sur la pièce en saillie (4).
